# FASCICULE DE BREVET EUROPEEN

(11) **EP 0 699 919 B1**
(45) Date de publication et mention de la délivrance du brevet: **05.11.2003**
(21) Numéro de dépôt: 95401993.1
(22) Date de dépôt: 01.09.1995
(51) Int. Cl.: G01R 31/12, G01R 15/09

(54) **Voie d'acquisition d'une impulsion en tension, procédé et système de mesure de décharges partielles pourvu d'une telle voie**
Erfassungskette für einen Spannungspuls, sowie Messverfahren und -system für Teilentladungen mit derselben
Acquisition route for voltage pulse and measuring procedure and system for partial discharges using such a route

(30) Priorité: 02.09.1994 FR 9410573
(43) Date de publication de la demande: 06.03.1996
(73) Titulaire: GEC ALSTHOM T & D SA, 75116 Paris (FR)
(72) Inventeur: Poittevin, Jean, F-92400 Courbevoie (FR); Ryadi, Mohamed, F-72000 Le Mans (FR); Bonnet, Jean Claude, F-78500 Sartrouville (FR); Mazankine, Jacques, F-78500 Sartrouville (FR)
(74) Mandataire: de Lambilly Delorme, Marie Pierre

(56) Documents cités:
- WO-A-90/01704
- GB-A- 2 034 140

## Description

L'invention concerne une voie d'acquisition d'une impulsion en tension, un procédé de mesure de décharges partielles mis en oeuvre dans un système de mesure de décharges partielles comprenant au moins une telle voie.

Les décharges partielles se produisent notamment dans les équipements utilisés dans les installations à haute tension des réseaux de transport ou de distribution d'énergie électrique. Une décharge partielle est un phénomène de rupture diélectrique se produisant dans une partie seulement de l'isolant séparant deux conducteurs sans que cela n'entraîne le claquage complet des composants concernés.

La signature d'une décharge partielle en divers points de l'appareil l'ayant subi, peut fournir des indications sur le vieillissement de certains composants. De ce fait l'analyse de ces signatures peut améliorer sensiblement les moyens de maintenance prédictive notamment dans les installations électriques à haute tension.

On connaît des systèmes d'acquisition de décharges partielles mono-voie permettant d'obtenir une moyenne des décharges partielles détectées dans une demie période de la tension de référence. Si l'on souhaite pouvoir réaliser une maintenance prédictive de qualité, il est nécessaire de déterminer la signature la plus exacte des décharges partielles. Une moyenne sur une demie période entraîne des pertes d'information.

Avec les systèmes d'acquisition mono-voie décrits ci-dessus, le calibrage des signaux reçus est manuel. Or une décharge partielle peut générer des signaux impulsionnels d'amplitude extrêmement variable allant de quelques millivolts à quelques centaines de volts. De plus ces impulsions interviennent en quelques microsecondes. De ce fait un calibrage manuel des signaux n'est pas efficace. Il y a perte d'informations si le calibre choisi ne permet pas de détecter certains signaux de faible amplitude par rapport au calibre choisi, et informations erronées sur les signaux de grande amplitude venant saturer le calibre choisi. En outre un réglage manuel nécessite la présence continuelle d'un opérateur extrêmement vigilant.

Enfin ces appareils sont mono-voie. Or pour une maintenance prédictive efficace il est convenable de recueillir la signature de la décharge partielle en divers points de mesure et de recouper les informations obtenues. Dans le cas de ces appareils il est donc nécessaire d'utiliser autant d'appareils mono-voie que de points de mesure.

On connaît des systèmes de mesure de décharges partielles multi-voies qui permettent d'obvier au dernier inconvénient. Un tel système est décrit dans FR-A-2635192.

Ce système comprend plusieurs voies, chacune ayant:
- une entrée de voie d'un signal d'impulsion présent à un point de mesure de l'appareil électrique;
- un module de détermination de polarité et limitation d'acquisition, pour déterminer la polarité du signal d'entrée, et pour limiter l'acquisition d'impulsion à un signal d'entrée dépassant des valeurs seuil prédéterminées;
- un module de détection et de maintien pour détecter la valeur crête polarisée du signal en cours d'acquisition, et maintenir cette valeur pendant un temps donné; et,
- un module de commande.

Toutes les voies sont connectées à un ordinateur ou équivalent par l'intermédiaire d'une même interface multiplexeur qui numérise le résultat de l'acquisition de chaque voie l'une après l'autre.

Ce système ne permet aucune opération de calibrage. Il y a donc perte d'informations si le calibre de la voie ne permet pas de détecter certains signaux de faible amplitude, et informations erronées sur les signaux de grande amplitude venant saturer le calibre.

De plus l'utilisation d'un seul dispositif de numérisation pour l'ensemble des voies par l'intermédiaire d'un multiplexage, induit des temps de stockage des données trop importants augmentant le temps minimal nécessaire pour effectuer une mesure sur une voie. Cette augmentation peut être à l'origine de la perte de la mesure d'une décharge qui interviendrait pendant une mesure en cours.

L'un des buts de la présente invention est de fournir des voies ayant des modules automatisés de gestion du calibrage, de manière que, pour une amplitude d'un signal, le module choisisse le calibrage optimal de mesure.

Un autre but de la présente invention est de rendre les voies autonomes en matière de numérisation et de stockage de donnée de manière à diminuer le temps nécessaire pour effectuer une mesure.

Un autre but de la présente invention est de fournir un procédé et un système de mesure multi-voies permettant le post-traitement d'une série de mesure, sans pour autant interrompre les mesures en cours.

A cet effet l'invention concerne une voie d'acquisition d'une impulsion en tension mesurée dans un appareil électrique. Cette voie comprend:
- une entrée de voie d'un signal d'impulsion présent à un point de mesure dudit appareil électrique;
- un module de détermination de polarité et limitation d'acquisition, pour déterminer la polarité du signal d'entrée, et pour limiter l'acquisition d'impulsion à un signal d'entrée dépassant des valeurs seuil prédéterminées;
- un module de commande pour commander l'acquisition et la mémorisation de la valeur crête polarisée du signal d'entrée si le signal d'entrée dépasse les valeurs seuil prédéterminées;
- au moins un module de détection et de maintien pour détecter la valeur crête polarisée du signal en cours d'acquisition et maintenir cette valeur pendant un temps donné; et,
- un module de sélection pour sélectionner le calibre du signal en cours d'acquisition.

Selon l'invention, le module de sélection pour sélectionner le calibre du signal en cours d'acquisition comprend une pluralité de gammes de mesure, toutes connectées, en amont, à l'entrée de la voie, et, en aval, à des moyens de sélection automatiques pour sélectionner automatiquement la gamme de mesure optimale pour le signal en cours d'acquisition. On permet ainsi un calibrage de mesure automatique optimal du signal d'entrée.

Chaque gamme de mesure comprend un module de détection et de maintien.

Selon l'invention, chaque gamme de mesure comprend un amplificateur de gain connu, et de tension de saturation connue, les moyens de sélection automatique comprenant des moyens pour balayer la pluralité de gammes de mesure dans un sens décroissant des gains d'amplification et des moyens pour sélectionner la première gamme de mesure non saturée dans l'ordre de balayage.

Le module de détection et de maintien est avantageusement localisé en aval de l'amplificateur et en amont des moyens de sélection automatique dans chaque gamme de mesure.

Le module de détection et de maintien comprend des moyens de détection et de maintien analogique en série avec des moyens de numérisation de la valeur crête polarisée détectée et maintenue.

La voie d'acquisition selon l'invention comprend des moyens de mémorisation de la valeur crête polarisée détectée numérisée et sélectionnée en sortie du module de sélection.

Avantageusement la voie selon l'invention comprend des moyens de réglage pour régler les valeurs seuil prédéterminées, et des moyens de sélection commandable pour sélectionner la gamme de mesure devant être connectée au module de détermination de polarité et de limitation d'acquisition.

L'invention concerne en outre un système pour mesurer les décharges partielles dans un appareil électrique comprenant :
- au moins une voie d'acquisition telle que décrite ci-dessus;
- une voie de référence pour numériser et stocker la tension d'alimentation polarisée de l'appareil électrique; et,
- un module de transfert dans un fichier commun d'archivage et de post traitement, des valeurs crête polarisées numérisées stockées dans le module de mémorisation de la voie d'acquisition, et de la tension d'alimentation polarisée stockée mémorisée dans la voie de référence, ledit fichier commun étant localisé dans un micro-ordinateur ou équivalent.

Le micro-ordinateur ou équivalent comprend des moyens de traitement des données du fichier commun et des moyens de visualisation et d'édition desdites données ou des résultats des traitements.

Avantageusement le système comprend sept voies d'acquisition et une voie de référence, chaque voie d'acquisition comprenant quatre gammes de mesure à recouvrement permettant une dynamique de mesure d'environ un million.

L'invention concerne enfin un procédé d'acquisition selon lequel :
- on connecte les voies d'acquisition aux points de mesure choisis dans l'appareil électrique;
- on connecte la voie de référence à une des tensions d'alimentation de l'appareil électrique;
- un signal attaque l'entrée de la voie d'acquisition. Ce signal est distribué dans toutes les gammes de mesure, et, par l'intermédiaire du moyen de sélection commandable, dans le module de détermination de polarité et limitation d'acquisition.
- Le module de détermination de polarité et limitation d'acquisition détermine la polarité du signal, et compare la valeur du signal avec les valeurs seuil, et dans le cas où ces valeurs seuil sont dépassées, il génère un ordre de commande à tous les module de détection et de maintien, et au module de commande qui démarre une temporisation avec les moyens de décalage.
- Durant cette temporisation, les modules de détection et de maintien ont le temps de détecter la valeur crête du signal grâce aux moyens analogiques. A l'issue de la temporisation, le module de commande active les moyens de numérisation, pour qu'ils numérisent la valeur crête du signal.
- Durant cette temporisation, ou à l'issue de celle-ci le module de commande génère un ordre d'acquisition pour la voie de référence. Celle-ci acquière, numérise, et mémorise le numéro de la période, et la valeur polarisée de la tension de référence à cet instant.
- Les moyens de sélection automatique balayent les gammes de mesure dans le sens décroissant des gains, et sélectionne la première valeur numérisée qui est inférieure au seuil de saturation de la gamme de mesure d'où elle est issue.
- Le module de commande lance alors la mise en mémoire de la valeur sélectionnée, puis active la réinitialisation des modules pour attendre un nouveau signal.

Un premier avantage de la présente invention est le calibrage automatique du signal d'entrée, grâce au module de sélection. Ainsi toute acquisition est justement calibrée et ne constitue plus un vecteur potentiel d'information erronée. En outre ce module automatique ne nécessite aucun opérateur.

Un autre avantage de la présente invention est l'intégration au sein de chaque voie d'un dispositif de numérisation. Cela augmente sensiblement la vitesse d'acquisition. En effet chaque voie peut numériser et stocker ses propres données indépendamment des autres voies.

D'autres avantages et caractéristiques de la présente invention résulterons de la description qui va suivre en référence aux dessins annexés dans lesquels :

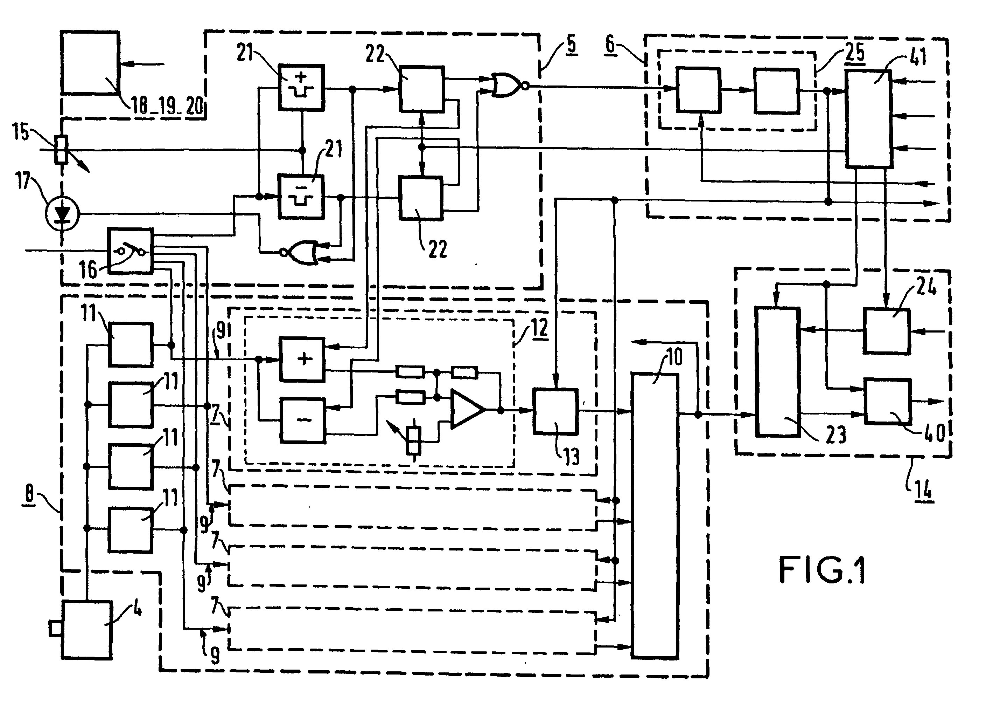

- la figure 1 est une représentation schématique d'une voie selon l'invention;

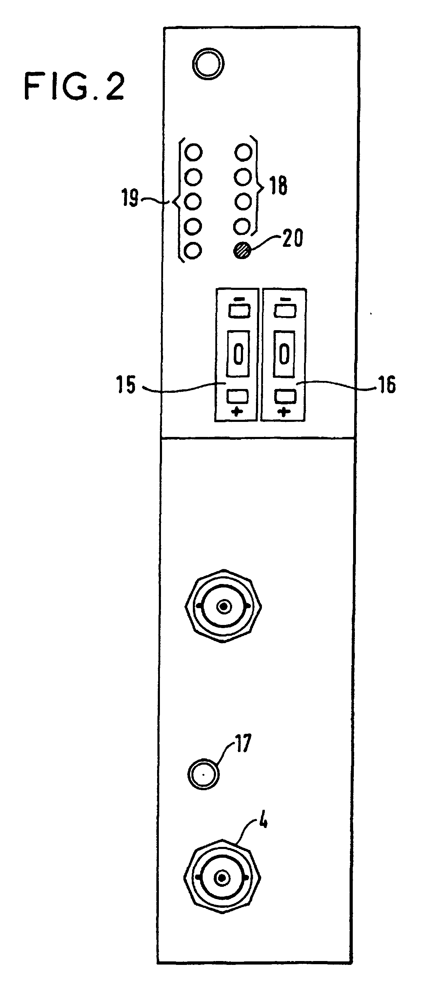

- la figure 2 est une représentation schématique extérieure du tableau de bord d'une voie selon l'invention;

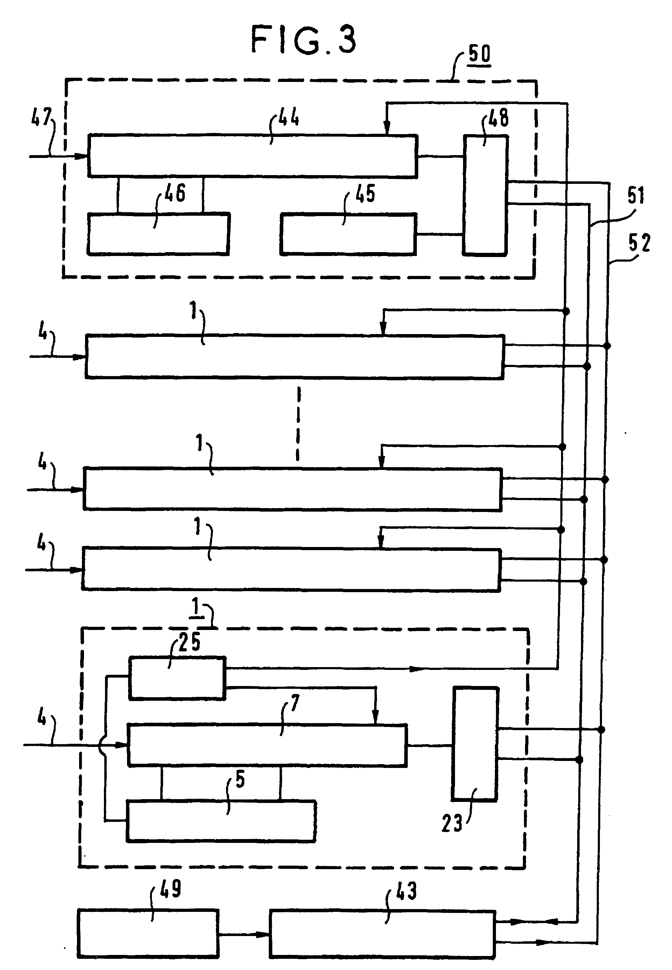

- la figure 3 est un diagramme synoptique schématique d'un système selon l'invention.
- les figures 4A, 4B, 4C, 4D sont des représentations schématiques d exemples de visualisation de données traitées ou non selon l'invention.

La voie 1 selon l'invention comprend une entrée de voie 4 d'un signal d'impulsion détecté à un point de mesure d'un appareil électrique.

Cette entrée de voie 4 est connectée en sortie à l'entrée d'un module de sélection 8 pour sélectionner le calibre du signal en cours d'acquisition.

Ce module de sélection 8 est connecté en sortie, d'une part à l'entrée d'un module de détermination de polarité et limitation d'acquisition 5 pour déterminer la polarité du signal d'entrée, et pour limiter l'acquisition d'impulsion à un signal d'entrée dépassant des valeurs seuil prédéterminées, et, d'autre part à l'entrée d'un module de mémorisation 14 des paramètres relatifs au signal acquis.

Le module de détermination de polarité et limitation d'acquisition 5 est connecté en sortie, d'une part, à une entrée de commande d'au moins un module de détection et de maintien 7 pour détecter la valeur crête polarisée du signal en cours d'acquisition et maintenir cette valeur pendant un temps donné, et, d'autre part, à l'entrée interne d'un module de commande 6 pour commander l'acquisition et la mémorisation de la valeur crête polarisée du signal d'entrée si le signal d'entrée dépasse les valeurs seuil prédéterminées.

Le module de commande 6 est connecté, en sortie, aux entrées de commande du module de mémorisation 14, aux entrées de commande d'au moins un module de numérisation 13 de la valeur crête polarisée détectée, et présente une entrée / sortie externe 41.

Le module de mémorisation présente une entrée / sortie externe 40.

Avantageusement l'entrée 4 comprend un circuit à réactance destiné à fixer l'impédance d'entrée de la voie, la coupure haute de la bande passante, et la protection en tension des circuits en aval.

Le module de sélection 8 pour sélectionner le calibre du signal en cours d'acquisition comprend une pluralité de gammes de mesure 9, toutes connectées, en amont, à l'entrée de la voie 4, et, en aval, à des moyens de sélection automatiques 10 pour sélectionner automatiquement la gamme de mesure 9 optimale pour le signal en cours d'acquisition.

Chaque gamme de mesure 9 comprend un module de détection et de maintien 7.

Chaque gamme de mesure 9 comprend en outre au moins un amplificateur 11 de gain connu, de tension de saturation connue, les moyens de sélection automatique comprenant des moyens pour balayer la pluralité de gammes de mesure 9 dans un sens décroissant des gains d'amplification et des moyens pour sélectionner la première gamme de mesure 9 non saturée dans l'ordre de balayage.

Le module de détection et de maintien 7 est avantageusement localisé en aval de l'amplificateur 11 et en amont des moyens de sélection automatique 10.

Le module de détection et de maintien 7 comprend des moyens de détection et de maintien analogique 12, commandés par le module de détermination de polarité et limitation d'acquisition 5, et, monté en série, un module de numérisation 13 commandé par le module de commande 6.

Chaque module de numérisation 13 est connecté aux moyens de sélection automatique 10, lesdites moyens de sélection automatique 10 étant connectés à l'entrée du module de mémorisation 14.

Toutes les sorties d'amplificateur 11 sont, en outre, connectées à un moyen de sélection commandable 16 du module de détermination de polarité et limitation d'acquisition 5. Ce moyen de sélection est commandable manuellement où par programmation. Il sélectionne un des signaux amplifiés. Ce moyen de sélection commandable est connecté à l'entrée d'un ensemble de deux comparateurs 21 et de deux bascules 22 qui permettront de déterminer la polarité du signal d'entrée, et de limiter l'acquisition d'impulsion à un signal d'entrée dépassant les valeurs seuil prédéterminées.

Le module de détermination de polarité et limitation d'acquisition 5 comprend en outre des moyens 15 de réglage des valeurs seuils connectés aux pattes de référence des comparateurs 21. Les sorties de commande des bascules sont connectées d'une part à l'entrée interne du module de commande 6 et d'autre part, à l'entrée de commande de chacun des modules de détection et de maintien 12.

Le module de commande 6 comprend un moyen de décalage 25, pour permettre aux modules de détection et de maintien 12 de détecter la valeur crête ; des moyens pour commander les modules de numérisation 13 ; et des moyens pour gérer le module de mémorisation 14.

Le module de commande 6 peut en outre comprendre son propre processeur. Dans le mode de réalisation représenté, le module de commande 6 est synchronisé par un processeur extérieur connecté à l'entrée externe du module de commande 6.

Le module de mémorisation comprend classiquement une mémoire 23, un générateur d'adresses mémoire 24 commandé par le module de commande 6. Il comporte en outre une sortie externe de transfert des données stockées.

Avantageusement la voie 1 comprend un module de visualisation 17, 18, 19, 20 comprenant à titre d'exemples non limitatifs des moyens de visualisation de dépassement des valeurs seuil 17, de gamme sélectionnée 18, d'amplitude du signal dans la gamme sélectionnée 19, et, de polarité 20.

L'invention concerne aussi un système de mesure de décharges partielles dans un appareil électrique.

Ledit système comprend au moins une voie 1 telle que décrite ci-dessus ; une voie de référence 50 pour numériser et mémoriser une tension de référence polarisée de l'appareil électrique, par exemple non limitatif une des tensions d'alimentation de l'appareil électrique ; et, un module de transfert 43 pour transférer les valeurs crête polarisées sélectionnées et mémorisées dans le module de mémorisation 14, et les données associées relatives à la tension de référence polarisée durant l'acquisition, dans un fichier commun d'archivage et de post-traitement, localisé dans un micro-ordinateur 49 ou équivalent. Chaque voie d'acquisition 1 donne lieu à un fichier commun d'archivage et de post-traitement. Les données contenues dans ce fichier sont, à titre d'exemple non limitatif, l'amplitude de chaque décharge détectée, leur polarité, leur positionnement dans le temps, c'est à dire par rapport à la tension de référence (numéro de la période de référence, et valeur de la tension de référence au moment de l'impulsion). Les moyens de transfert peuvent être activés après chaque mesure, ou à l'issue d'une série de mesures (campagne de mesure), ou dés qu'intervient un temps mort (pas de signal) sur la voie considérée.

La voie de référence 50 comprend :
- une entrée de référence 47, connectée à une tension de référence;
- un module de détermination de polarité et limitation d'acquisition 46;
- un module 47 de détection, de maintien, et de numérisation de la tension de référence polarisée;
- un module 45 compteur de périodes de la tension de référence;
- un module de mémorisation 48 de la tension de référence polarisée numérisée et du numéro de la période associée;
l'ensemble des modules de la voie de référence étant commandé en acquisition de valeur référence par n'importe quelle voie d'acquisition 1 au moment où cette dernière est elle même en phase d'acquisition d'une valeur crête polarisées d'une décharge.

Le module de transfert comprend un bus de données 51 connecté aux mémoires 23, 48 des voies 1, 50; et un bus de commande 52 pour sélectionner la voie à mettre en communication avec le micro-ordinateur 49 ou équivalent.

Le micro-ordinateur 49 ou équivalent comprend des moyens de traitement, et des moyens de visualisation et d'édition du fichier commun ou des éléments issus d'un traitement dudit fichier commun.

Les étapes d'acquisition d'une mesure sont les suivantes :
- un signal attaque l'entrée 4 de la voie 1. Ce signal est distribué dans toutes les gammes de mesure 9, et par l'intermédiaire du moyen de sélection commandable 16 dans le module de détermination de polarité et limitation d'acquisition 5.
- Le module de détermination de polarité et limitation d'acquisition 5 détermine la polarité du signal, et compare la valeur du signal avec les valeurs seuil, et dans le cas où ces valeurs seuil sont dépassées, il génère un ordre de commande à tous les module de détection et de maintien 7, et au module de commande 6 qui démarre une temporisation avec les moyens 25 de décalage.
- Durant cette temporisation, les modules de détection et de maintien 7 ont le temps de détecter la valeur crête du signal grâce aux moyens 12 analogique. A l'issue de la temporisation, le module de commande 6 active le module de numérisation 13, pour qu'ils numérise la valeur crête du signal.
- Durant cette temporisation, ou à l'issue de celle-ci le module de commande 6 génère un ordre d'acquisition pour la voie de référence. Celle-ci acquière, numérise, et mémorise le numéro de la période, et la valeur polarisée de la tension de référence à cet instant.
- Les moyens de sélection automatique 10 balayent les gammes de mesure dans le sens décroissant des gains, et sélectionne la première valeur numérisée qui est inférieure au seuil de saturation de la gamme de mesure d'où elle est issue.
- Le module de commande 6 lance alors la mise en mémoire de la valeur sélectionnée, puis active la réinitialisation des modules pour attendre un nouveau signal.

Dans un premier mode de réalisation, dit en salve, l'étape de transfert intervient à l'issue d'une campagne de mesure. Ce type de transfert est suffisant lorsque l'on souhaite tester un appareil de façon ponctuelle.

Dans un deuxième mode de réalisation, dit à la volée, l'étape de transfert intervient dans les temps morts entre deux acquisitions au cours de la campagne de mesure. Ce type de transfert est nécessaire lorsque l'on surveille en continu un appareil et que l'on souhaite pouvoir traiter les acquisitions sans interrompre la surveillance. Ce type de transfert est plus efficace en matière de maintenance prédictive.

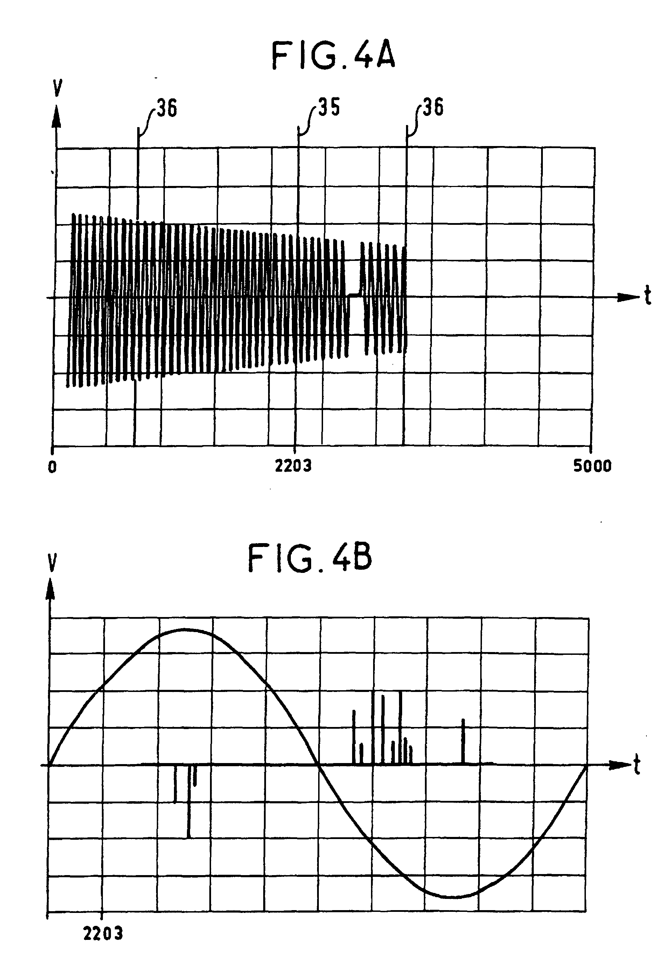

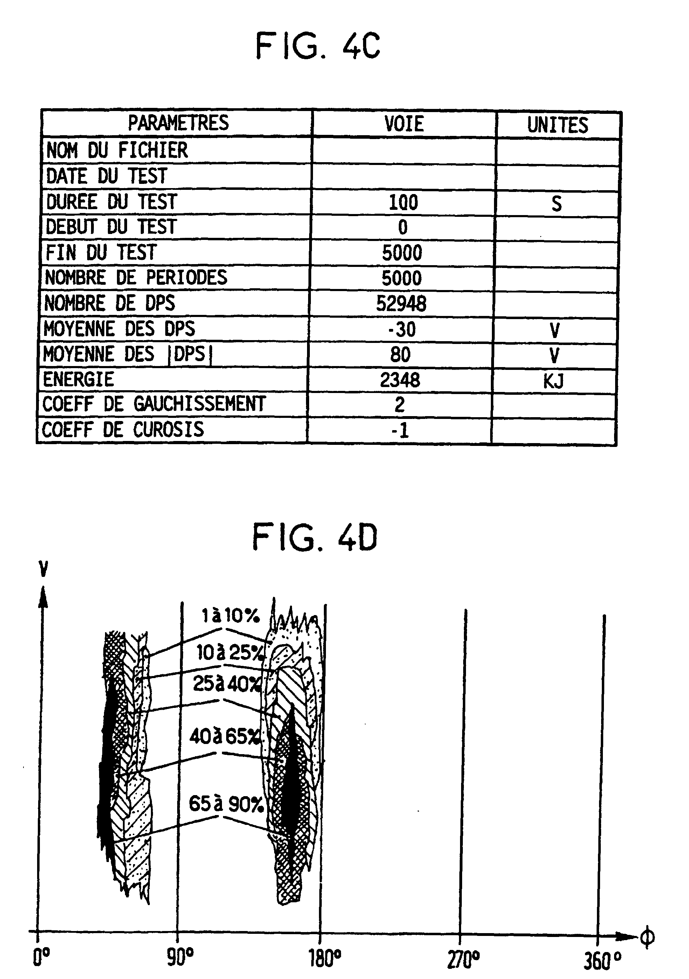

Sur les figures 4A, 4B, 4C, 4D sont représentés à titre d'exemple non limitatif quatre affichages possibles selon l'invention.

Le premier affichage propose l'ensemble d'une campagne de mesure.

Le système comprend des moyens de curseur 35, 36 permettant d'une part de se positionner sur l'une quelconque des périodes de la tension de référence de la campagne de mesure, et d'autre part de sélectionner une partie seulement de la campagne de mesure.

Le deuxième affichage propose l'amplitude et la polarité des décharges intervenues durant la période sélectionnée par le curseur 35 de l'affichage précèdent.

Le troisième affichage propose une liste de paramètres prédéterminés, calculés à partir de la partie de la campagne de mesure sélectionnée par les curseurs 36 de l'affichage précédent.

Le quatrième affichage propose un schéma d'occurrence des décharges en fonction de leurs amplitudes et du déphasage avec la tension de référence.

## Revendications

1. Voie d'acquisition d'une impulsion en tension mesurée dans un appareil électrique, la dite voie comprenant :
- une entrée de voie (4) d'un signal d'impulsion détecté à un point de mesure dudit appareil électrique;
- un module de détermination de polarité et limitation d'acquisition (5), pour déterminer la polarité du signal d'entrée, et pour limiter l'acquisition d'impulsion à un signal d'entrée dépassant des valeurs seuil prédéterminées;
- un module de commande (6) pour commander l'acquisition et la mémorisation de la valeur crête polarisée du signal d'entrée si le signal d'entrée dépasse les valeurs seuil prédéterminées;
- un module de détection et de maintien (7) pour détecter la valeur crête polarisée du signal en cours d'acquisition et la maintenir pendant un temps donné prédéterminé; et,
- un module de sélection pour sélectionner le calibre du signal en cours d'acquisition;
**caractérisée en ce que** le module de sélection (8) pour sélectionner le calibre du signal en cours d'acquisition comprend une pluralité de gammes de mesure (9), toutes connectées, en amont, à l'entrée de la voie (4), et, en aval, à des moyens de sélection automatiques (10) pour sélectionner automatiquement la gamme de mesure (9) optimale pour le signal en cours d'acquisition.

2. Voie d'acquisition selon la revendication 1 **caractérisée en ce que** chaque gamme de mesure (9) comprend un module de détection et de maintien (7).

3. Voie d'acquisition selon la revendication 1 ou 2 **caractérisée en ce que** chaque gamme de mesure (9) comprend un amplificateur (11) de gain connu, de tension de saturation connue, les moyens de sélection automatique (10) comprenant des moyens pour balayer la pluralité de gammes de mesure (9) dans un sens décroissant des gains d'amplification et des moyens pour sélectionner la première gamme de mesure (9) non saturée dans l'ordre de balayage.

4. Voie d'acquisition selon la revendication 3 **caractérisée en ce que** le module de détection et de maintien (7) est localisé en aval de l'amplificateur (11) et en amont des moyens de sélection automatique (10).

5. Voie d'acquisition selon l'une quelconque des revendications 1 à 4 **caractérisée en ce que** le module de détection et de maintien (7) comprend des moyens de détection et de maintien analogique (12) en série avec des moyens de numérisation (13) de la valeur crête polarisée détectée.

6. Voie d'acquisition selon l'une quelconque des revendications 1 à 5 **caractérisée en ce qu'**elle comprend un module de mémorisation (14) de la valeur crête polarisée détectée et sélectionnée en sortie des moyens de sélection automatique (10).

7. Voie d'acquisition selon l'une quelconque des revendications 1 à 6 **caractérisée en ce qu'**elle comprend des moyens de réglage (15) pour régler les valeurs seuil prédéterminées, et des moyens de sélection commandable (16) pour sélectionner la gamme de mesure (9) devant être connectée au module de détermination de polarité et de limitation d'acquisition (5).

8. Système de mesure de décharges partielles dans un appareil électrique **caractérisé en ce qu'**il comprend :
- au moins une voie d'acquisition (1) selon les revendications 1 à 7;
- une voie de référence (50) pour numériser et stocker la tension d'alimentation polarisée de l'appareil électrique, synchronisée avec la voie d'acquisition (1); et,
- un module de transfert (43) pour transférer, dans un fichier commun d'archivage localisé dans un micro-ordinateur (49) ou équivalent, les valeurs crête polarisées numérisées stockées dans le module de mémorisation (14) de la voie d'acquisition (1), et la tension polarisée d'alimentation associée stockée mémorisée dans la voie de référence.

9. Système selon la revendication 8 **caractérisé en ce qu'**il comprend des moyens de traitement des données du fichier commun et des moyens de visualisation et d'édition desdites données ou des résultats des traitements.

10. Système selon la revendication 8 ou 9 **caractérisé en ce qu'**il comprend sept voies d'acquisition (1) et une voie de référence, chaque voie d'acquisition (1) comprenant quatre gammes de mesure (9) qui permettent en combinaison une dynamique de mesure d'environ un million.

11. Procédé de mesure de décharges partielles et de traitement desdites mesures avec un système de mesure selon les revendications 8 à 10 dans lequel:
- on connecte les voies d'acquisition (1) aux points de mesure choisis dans l'appareil électrique;
- on connecte la voie de référence à une des tensions d'alimentation de l'appareil électrique;
pour chaque voie (1) :
- un signal attaque l'entrée (4) de la voie (1), ce signal étant distribué dans toutes les gammes de mesure (9), et par l'intermédiaire du moyen de sélection commandable (16) dans le module de détermination de polarité et limitation d'acquisition (5);
- le module de détermination de polarité et limitation d'acquisition (5) détermine la polarité du signal, et compare la valeur du signal avec les valeurs seuil, et dans le cas où ces valeurs seuil sont dépassées, il génère un ordre de commande à tous les module de détection et de maintien (7), et au module de commande (6) qui démarre une temporisation avec les moyens (25) de décalage.
- durant cette temporisation, les modules de détection et de maintien (7) détectent la valeur crête du signal grâce aux moyens (12) analogiques;
- durant cette temporisation, ou à l'issue de celle-ci le module de commande (6) génère un ordre d'acquisition pour la voie de référence qui acquière, numérise, et mémorise le numéro de la période, et la valeur polarisée de la tension de référence à cet instant;
- à l'issue de la temporisation, le module de commande (6) commande les moyens de numérisation (13), pour qu'ils numérisent la valeur crête du signal;
- les moyens de sélection automatique (10) balayent les gammes de mesure (9) dans le sens décroissant des gains; et sélectionne la première valeur numérisée qui est inférieure au seuil de saturation de la gamme de mesure (9) d'où elle est issue;
- le module de commande (6) commande alors la mise en mémoire de la valeur sélectionnée dans le module de mémorisation (14), puis commande la remise à zéro des modules pour attendre un nouveau signal;
- les données ainsi recueillies sont transférées dans le fichier commun pour être archivées et / ou post-traitées.

12. Procédé selon la revendication 11 **caractérisé en ce que** l'étape de transfert à lieu à l'issue d'une campagne de mesure d'un temps donné.

13. Procédé selon la revendication 11 **caractérisé en ce que** l'étape de transfert s'effectue au cours d'une campagne de mesure, dans les temps morts où aucune décharge n'est détectée.

## Claims

1. A path for acquiring a voltage pulse measured in an electrical apparatus, said path comprising:
a path input (4) for a pulse signal detected at a measurement point of said electrical apparatus;
a module (5) for determining polarity and for limiting acquisition to detect the polarity of the input signal and to limit pulse acquisition to input signals exceeding predetermined threshold values;
a control module (6) for controlling acquisition and storage of the polarized peak value of the input signal if the input signal exceeds the predetermined threshold values;
a detect-and-hold module (7) for detecting the polarized peak value of the signal being acquired and for holding it during a predetermined given length of time; and
a selection module for selecting the rating of the signal being acquired;
the acquisition path being **characterized in that** the selection module (8) for selecting the rating of the signal being acquired comprises a plurality of measurement ranges (9), all connected at their upstream ends to the input of the path (4), and all connected at their downstream ends to the automatic selection means (10) for automatically selecting the measurement range (9) which is optimum for the signal being acquired.

2. An acquisition path according to claim 1, **characterized in that** each measurement range (9) includes a detect-and-hold module (7).

3. An acquisition path according to claim 1 or 2, **characterized in that** each measurement range (9) includes an amplifier (11) of known gain and of known saturation voltage, the automatic selection means (10) including means for scanning the plurality of measurement ranges (9) in order of decreasing amplifier gain, and means for selecting the first non-saturated measurement range (9) in scan order.

4. An acquisition path according to claim 3, **characterized in that** the detect-and-hold module (7) is located downstream from the amplifier (11) and upstream from the automatic selection means (10).

5. An acquisition path according to any one of claims 1 to 4, **characterized in that** the detect-and-hold module (7) comprises analog detect-and-hold means (12) connected in series with digitizing means (13) for digitizing the detected polarized peak value.

6. An acquisition path according to any one of claims 1 to 5, **characterized in that** it includes a storage module (14) for storing the detected polarized peak value as selected and made available at the output of the automatic selection means (10).

7. An acquisition path according to any one of claims 1 to 6, **characterized in that** it includes adjustment means (15) for adjusting the predetermined threshold values, and controllable selection means (16) for selecting the measurement range (9) to be connected to the module (5) for determining polarity and for limiting acquisition (5).

8. A system for measuring partial discharges in an electrical apparatus, the system being **characterized in that** it comprises:
at least one acquisition path (1) according to any one of claims 1 to 7;
a reference path (50) for digitizing and storing the polarized feed voltage of the electrical apparatus synchronously with the acquisition path (1); and
a transfer module (43) for transferring to a common archive file located in a microcomputer (49) or equivalent, the digitized polarized peak values as stored in the storage module (14) of the acquisition path (1), together with the associated feed polarized voltage as stored in the reference path.

9. A system according to claim 8, **characterized in that** it includes means for processing the data in the common file and display means and means for outputting said data or the results of processing said data.

10. A system according to claim 8 or 9, **characterized in that** it comprises seven acquisition paths (1) and one reference path, each acquisition path (1) having four measurement ranges (9) which in combination provide a dynamic measurement range of about one to one million.

11. A method of measuring partial discharges and of processing said measurements using a measurement system according to any one of claims 8 to 10, in which:
the acquisition paths (1) are connected to measurement points selected in the electrical apparatus;
the reference path is connected to one of the feed voltages of the electrical apparatus;
for each path (1):
an input signal (4) becomes available for the path (1), this signal being distributed among all of the measurement ranges (9) and via the controllable selection means (16) in the module (5) for determining polarity and limiting acquisition;
the module (5) for determining polarity and limiting acquisition determines the polarity of the signal and compares the value of the signal with the threshold values, and when said threshold values are exceeded, it generates a trigger command applied to all of the detect-and-hold modules (7) and to the control module (6) which starts a time delay using the shift means (25);
during the time delay, the detect-and-hold modules (7) detect the peak value of the signal by using the analog means (12);
during the time delay, or at the end thereof, the control module (6) generates an acquisition command for the reference path which then acquires, digitizes, and stores the number of the period and the polarized value of the reference voltage at said instant;
at the end of the time delay, the control module (6) controls the digitizing means (13) to digitize the peak value of the signal;
the automatic selection means (10) scan the measurement ranges (9) in order of decreasing gain, and it selects the first digitized value which is below the saturation threshold of the measurement range (9) from which it is delivered;
the control module (6) then causes the selected value to be stored in the storage module (14), and then resets the modules to zero to wait for a new signal; and
the data collected in this way is transferred into the common file for archive purposes and/or for post-treatment purposes.

12. A method according to claim 11, **characterized in that** the transfer step takes place at the end of a measurement campaign lasting a given time.

13. A method according to claim 11, **characterized in that** the transfer step takes place during a measurement campaign, in idle periods during which no discharge is being detected.

## Patentansprüche

1. Pfad für die Erfassung eines in einem elektrischen Gerät gemessenen Spannungsimpulses, wobei der Pfad umfasst:
- einen Pfadeingang (4) für ein Impulssignal, das an einem Messpunkt des elektrischen Geräts ermittelt wird;
- ein Modul (5) für die Polaritätsbestimmung und die Erfassungsbeschränkung, um die Polarität des Eingangssignals zu bestimmen und um die Erfassung des Impulses auf ein Eingangssignal zu beschränken, das vorgegebene Schwellenwerte übersteigt;
- ein Steuermodul (6) zum Steuern der Erfassung und zum Speichern des polarisierten Spitzenwertes des Eingangssignals, falls das Eingangssignal die vorgegebenen Schwellenwerte übersteigt;
- ein Ermittlungs- und Haltemodul (7), das den polarisierten Spitzenwert des Signals während der Erfassung ermittelt und ihn für eine vorgegebene Zeitspanne hält; und
- ein Auswahlmodul, das die Größe des Signals während der Erfassung auswählt;
**dadurch gekennzeichnet, dass** das Auswahlmodul (8) zum Auswählen der Größe des Signals während der Erfassung mehrere Messbereiche (9) umfasst, die stromaufseitig alle mit dem Eingang des Pfades (4) und stromabseitig alle mit automatischen Auswahlmitteln (10), die automatisch den optimalen Messbereich (9) für das momentane Erfassungssignal auswählen, verbunden sind.

2. Erfassungspfad nach Anspruch 1, **dadurch gekennzeichnet, dass** jeder Messbereich (9) ein Ermittlungs- und Haltemodul (7) umfasst.

3. Erfassungspfad nach Anspruch 1 oder 2, **dadurch gekennzeichnet, dass** jeder Messbereich (9) einen Verstärker (11) mit bekannter Verstärkung für die bekannte Sättigungsspannung umfasst, wobei die automatischen Auswahlmittel (10) Mittel, die die mehreren Messbereiche (9) in Richtung abnehmender Verstärkungen abtasten, und Mittel, die den ersten nicht gesättigten Messbereich (9) in der Abtastreihenfolge auswählen, umfassen.

4. Erfassungspfad nach Anspruch 3, **dadurch gekennzeichnet, dass** das Ermittlungs- und Haltemodul (7) stromabseitig vom Verstärker (11) und stromaufseitig von den automatischen Auswahlmitteln (10) angeordnet ist.

5. Erfassungspfad nach einem der Ansprüche 1 bis 4, **dadurch gekennzeichnet, dass** das Ermittlungs- und Haltemodul (7) analoge Ermittlungs- und Haltemittel umfasst, die mit Mitteln (13) für die Digitalisierung des ermittelten polarisierten Spitzenwertes in Reihe geschaltet sind.

6. Erfassungspfad nach einem der Ansprüche 1 bis 5, **dadurch gekennzeichnet, dass** er ein Modul (14) für die Speicherung des ermittelten und ausgewählten polarisierten Spitzenwertes am Ausgang der automatischen Auswahlmittel (10) umfasst.

7. Erfassungspfad nach einem der Ansprüche 1 bis 6, **dadurch gekennzeichnet, dass** er Regelungsmittel (15) zum Regeln der vorgegebenen Schwellenwerte sowie steuerbare Auswahlmittel (16), die den Messbereich (9) auswählen, bevor er mit dem Polaritätsbestimmungs- und Erfassungsbeschränkungsmodul (5) verbunden wird, umfasst.

8. System zum Messen von Teilentladungen in einem elektrischen Gerät, **dadurch gekennzeichnet, dass** es umfasst:
- wenigstens einen Erfassungspfad (1) nach den Ansprüchen 1 bis 7;
- einen Referenzpfad (50), der die polarisierte Versorgungsspannung des elektrischen Gerätes digitalisiert und speichert und mit dem Erfassungspfad (1) synchronisiert ist; und
- ein Übertragungsmodul (43), das die in dem Speichermodul (14) des Erfassungspfades (1) gespeicherten digitalisierten polarisierten Spitzenwerte und die zugeordnete polarisierte Versorgungsspannung, die in dem Referenzpfad gespeichert ist, an eine gemeinsame Archivierungsdatei überträgt, die sich in einem Mikrocomputer (49) oder dergleichen befindet.

9. System nach Anspruch 8, **dadurch gekennzeichnet, dass** es Mittel für die Verarbeitung der Daten der gemeinsamen Datei und Anzeige- und Editierungsmittel für die Daten oder die Verarbeitungsergebnisse umfasst.

10. System nach Anspruch 8 oder 9, **dadurch gekennzeichnet, dass** es sieben Erfassungspfade (1) und einen Referenzpfad umfasst, wobei jeder Erfassungspfad (1) vier Messbereiche (9) umfasst, die in Kombination eine Messdynamik von etwa einer Million ermöglichen.

11. Verfahren zum Messen von Teilentladungen und zum Verarbeiten der Messwerte mit einem Messsystem nach den Ansprüchen 8 bis 10, bei dem:
- die Erfassungspfade (1) mit in dem elektrischen Gerät gewählten Messpunkten verbunden werden;
- der Referenzpfad mit einer der Versorgungsspannungen des elektrischen Geräts verbunden wird;
für jeden Pfad (1):
- ein Signal den Eingang (4) des Pfades (1) ansteuert, wobei dieses Signal auf alle Messbereiche (9) verteilt wird und über das steuerbare Auswahlmittel (16) in das Polaritätsbestimmungs- und Erfassungsbeschränkungsmodul (5) eingegeben wird;
- das Polaritätsbestimmungs- und Erfassungsbeschränkungsmodul (5) die Polarität des Signals bestimmt und den Wert des Signals mit den Schwellenwerten vergleicht und in dem Fall, in dem diese Schwellenwerte überschritten werden, einen Steuerbefehl für sämtliche Ermittlungs- und Haltemodule (7) und für das Steuermodul (6) erzeugt, das mit den Verzögerungsmitteln (25) eine Verzögerung beginnt;
- während dieser Verzögerung die Ermittlungs- und Haltemodule (7) den Spitzenwert des Signals kraft der analogen Mittel (12) ermitteln;
- während dieser Verzögerung oder an ihrem Ende das Steuermodul (6) einen Erfassungsbefehl für den Referenzpfad erzeugt, damit dieser die Nummer der Periode und den polarisierten Wert der Referenzspannung zu diesem Zeitpunkt erfasst. digitalisiert und speichert;
- am Ende der Verzögerung das Steuermodul (6) die Digitalisierungsmittel (13) steuert, damit sie den Spitzenwert des Signals digitalisieren;
- die automatischen Auswahlmittel (10) die Messbereiche (9) in Richtung abnehmender Verstärkungen abtasten und den ersten digitalisierten Wert, der kleiner ist als der Sättigungsschwellenwert des Messbereichs (9), von dem er stammt, auswählen;
- das Steuermodul (6) dann das Speichern des ausgewählten Wertes in dem Speichermodul (14) steuert und dann die Rücksetzung auf null der Module steuert, um ein neues Signal zu erwarten;
- die somit gesammelten Daten an die gemeinsame Datei übertragen werden, damit sie archiviert und/oder nachverarbeitet werden.

12. Verfahren nach Anspruch 11, **dadurch gekennzeichnet dass** der Übertragungsschritt nach einer Messzeitspanne mit gegebener Dauer ausgeführt wird.

13. Verfahren nach Anspruch 11, **dadurch gekennzeichnet, dass** der Übertragungsschritt während einer Messzeitspanne in den Totzeiten, in denen keine Entladung ermittelt wird, ausgeführt wird.
